# EUROPEAN PATENT APPLICATION

(11) **EP 3 904 814 A1**
(43) Date of publication of application: **03.11.2021**
(21) Application number: 19906123.5
(22) Date of filing: 24.12.2019
(51) Int. Cl.: F28D 15/06, F28D 15/02, H01L 23/427, H05K 7/20

(54) **EVAPORATOR AND LOOP-TYPE HEAT PIPE**

(30) Priority: 27.12.2018 JP 2018245275
(71) Applicant: Kawasaki Jukogyo Kabushiki Kaisha, Hyogo 650-8670 (JP)
(72) Inventor: HARUKI, Yu, Hyogo, 650-8670 (JP); SAKAGAWA, Keiji, Hyogo, 650-8670 (JP); HAKAMADA, Kazuhide, Hyogo, 650-8670 (JP); MITANI, Ryosuke, Hyogo, 650-8670 (JP)
(74) Representative: Dehns
(86) International application number: PCT/JP2019/050600
(87) International publication number: WO 2020/138082

(57) **Abstract**

An evaporator incorporated into a transportation machine includes: a plurality of heat exchange units that are aligned in a horizontal direction in the transportation machine placed on a horizontal surface and whose positions change together; a plurality of distribution conduits connected respectively to the heat exchange units to supply a working fluid in a liquid phase to the heat exchange units; and a plurality of valves disposed respectively in the distribution conduits to block passage of the working fluid flowing from the heat exchange units toward the distribution conduits at least when a tilt of the heat exchange units is equal to or greater than a predetermined threshold. Each heat exchange unit includes: an inlet portion connected to the distribution conduit; and a heat exchange portion that includes at least one heat exchange path extending straight upward from the inlet portion and that allows the working fluid passing through the heat exchange path to exchange heat with the heat source.

## Description

### Technical Field

The present invention relates to an evaporator and a loop heat pipe including the evaporator.

### Background Art

A loop heat pipe technology has been traditionally known which uses phase changes of a working fluid to achieve high-density heat transport. A heat transport system employing such a loop heat pipe has been used, for example, to cool an electronic device such as a computer or home electric appliance. In some loop heat pipes, the working fluid is circulated by means of capillary force and/or gravity.

A loop heat pipe includes a closed loop formed by an evaporator, a condenser, a vapor conduit leading from the evaporator to the condenser, and a liquid conduit leading from the condenser to the evaporator. The closed loop is charged with a working fluid. In the evaporator, the working fluid in a liquid phase is heated by heat transferred from a heat-generating element, and a part of the working fluid changes into a gas phase. The gas-liquid two-phase working fluid moves in the vapor conduit under the action of pressure difference and buoyancy and reaches the condenser. In the condenser, the working fluid is cooled into the liquid phase. The liquid-phase working fluid returns to the evaporator under the action of capillary force and/or gravity. In this manner, the loop heat pipe allows the working fluid to circulate in the two-phase closed loop and transport heat from the evaporator to the condenser, thereby cooling the heat-generating element thermally connected to the evaporator.

Patent Literature 1 discloses a loop heat pipe configured as an exhaust heat recovery device to recover exhaust heat from a water-cooled engine mounted on a vehicle. The loop heat pipe includes an evaporator that effects heat exchange between exhaust gas from the water-cooled engine and a working fluid (water) flowing in the evaporator. The evaporator includes: a heat exchange portion made up of a heat transfer conduit extending straight in the vertical direction and a fin, the heat transfer conduit and fin being stacked together; a lower pipe connected to lower ends of a plurality of tubes; and an upper pipe connected to upper ends of the tubes.

### Citation List

### Patent Literature

PTL 1: Japanese Laid-Open Patent Application Publication No. 2007-333293

### Summary of Invention

### Technical Problem

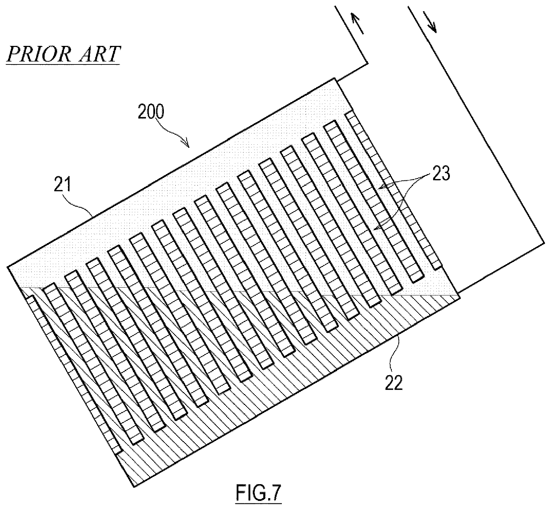

FIG. 7 illustrates the configuration of a prior art evaporator 200. The prior art evaporator 200 of FIG. 7 includes an inlet portion 22, an outlet portion 21 located above the inlet portion 22, and a plurality of heat exchange paths 23 extending in the vertical direction and connecting the inlet portion 22 and outlet portion 21. In the event that the evaporator 200 is tilted, the liquid-phase working fluid is unevenly distributed among the heat exchange paths 23 since the liquid-phase working fluid flows in the direction of decreasing potential energy. This could lead to some of the heat exchange paths 23 being ineffectively used because of the small amount of the liquid-phase working fluid, resulting in insufficient heat exchange between the working fluid and the heat source fluid.

The present invention has been made in view of the above circumstances and is directed to an evaporator including a plurality of heat exchange paths extending in the vertical direction and a loop heat pipe including the evaporator. An object of the present invention is to achieve less uneven distribution of the liquid-phase working fluid among the heat exchange paths in the event of tilting of the evaporator.

### Solution to Problem

An evaporator according to an aspect of the present invention is incorporated into a transportation machine to change at least a part of a working fluid from a liquid phase into a gas phase by heat absorbed from a heat source, and includes: a plurality of heat exchange units that are aligned in a horizontal direction in the transportation machine placed on a horizontal surface and whose positions change together; a plurality of distribution conduits connected respectively to the heat exchange units to supply the working fluid in the liquid phase to the heat exchange units; and a plurality of valves disposed respectively in the distribution conduits to block passage of the working fluid flowing from the heat exchange units toward the distribution conduits at least when a tilt of the heat exchange units is equal to or greater than a predetermined threshold, each heat exchange unit including: an inlet portion connected to the distribution conduit; and at least one heat exchange portion that includes a heat exchange path extending straight upward from the inlet portion and that allows the working fluid passing through the heat exchange path to exchange heat with the heat source.

A loop heat pipe according to an aspect of the present invention includes: the evaporator as defined above; a condenser that changes the working fluid from the gas phase into the liquid phase: a vapor conduit connecting an outlet of the evaporator and an inlet of the condenser; and a liquid conduit connecting an outlet of the condenser and an inlet of the evaporator.

In the evaporator and the loop heat pipe including the evaporator, the liquid-phase working fluid flows in the direction of decreasing potential energy in the event of tilting of the evaporator. In this situation, the valves block the flows of the working fluid from the heat exchange units toward the distribution conduits, thereby preventing the liquid-phase working fluid from flowing out of the heat exchange units into the distribution conduits or flowing out of one heat exchange unit into another heat exchange unit through the distribution conduits. Thus, the distribution of the liquid-phase working fluid among the heat exchange paths of the evaporator is less uneven than when the heat exchange units are in communication without intervention of the valves or when all of the heat exchange paths are in communication without intervention of the valves (see FIG. 7). This can decrease the number of the heat exchange paths in which the liquid-phase working fluid is not present (or the amount of the liquid-phase working fluid is small) in the event of tilting of the evaporator, resulting in effective use of the heat exchange paths.

### Advantageous Effects of Invention

The present invention can provide an evaporator including a plurality of heat exchange paths extending in the vertical direction and a loop heat pipe including the evaporator, the evaporator and loop heat pipe being adapted to achieve less uneven distribution of the liquid-phase working fluid among the heat exchange paths in the event of tilting of the evaporator.

### Brief Description of Drawings

FIG. 1 illustrates a schematic configuration of an aircraft incorporating a loop heat pipe according to an exemplary embodiment of the present invention.
FIG. 2 illustrates the configuration of an evaporator according to a first embodiment.
FIG. 3 illustrates the evaporator of FIG. 2 tilted from a reference position.
FIG. 4 illustrates the configuration of an evaporator according to a second embodiment.
FIG. 5 is a perspective view illustrating the configuration of an evaporator according to a third embodiment.
FIG. 6 is a schematic view illustrating the internal portion of the evaporator of FIG. 5.
FIG. 7 illustrates the configuration of a prior art evaporator.

### Description of Embodiments

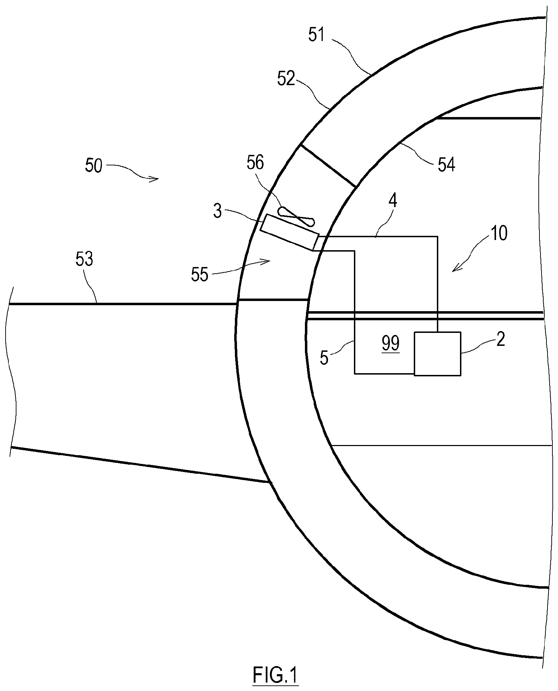

Hereinafter, exemplary embodiments of the present invention will be described with reference to the drawings. FIG. 1 illustrates an aircraft 50 which is an example of a transportation machine incorporating a loop heat pipe 10 according to an exemplary embodiment of the present invention.

The loop heat pipe 10 of FIG. 1 includes an evaporator 2, a vapor conduit 4, a condenser 3, and a liquid conduit 5, which form a closed loop. The closed loop is charged with a working fluid. The working fluid naturally circulates in the loop heat pipe 10 by making use of phase changes and gravity. The working fluid is not limited to particular fluids, and may be a condensable fluid commonly used as a working fluid in heat pipes. Examples of the condensable fluid include water, an alcohol, ammonia, a fluorocarbon, a hydrofluorocarbon, a hydrofluoroether, and a liquid mixture of these fluids.

In the evaporator 2, the working fluid in the liquid phase absorbs heat from a heat source fluid, and a part of the working fluid boils and changes into the gas phase. The gas-phase or gas-liquid two-phase working fluid moves in the vapor conduit 4 connecting the outlet of the evaporator 2 and the inlet of the condenser 3 under the action of pressure difference and buoyancy and reaches the condenser 3.

The condenser 3 is located above the evaporator 2. The condenser 3 is provided with a cooling path (not shown), and the gas-phase or two-phase working fluid releases heat and is cooled into the liquid phase during passage through the cooling path. The liquid-phase working fluid descends in the liquid conduit 5 connecting the outlet of the condenser 3 and the inlet of the evaporator 2 under the action of gravity and returns to the evaporator 2.

The above loop heat pipe 10 is suitable for incorporation into a transportation machine the position of which changes. Examples of the transportation machine include watercrafts (including submersibles), railcars, automobiles, and aircrafts.

FIG. 1 partially shows a fuselage 51 and main wing 53 of the aircraft 50. The fuselage 51 has a multilayer portion including an outer panel 52 and an inner wall 54 located closer to the cabin than the outer panel 52. Between the outer panel 52 and inner wall 54 is defined a cooling chamber 55. The temperature inside the cooling chamber 55 is low because of cold energy transferred from the outer panel 52 which during flight is exposed to outside air having a considerably lower temperature than that near the ground. Alternatively, the outer panel 52 may be provided with an air inlet and air outlet communicating with the cooling chamber 55, and the outside air may be introduced into the cooling chamber 55 during flight.

The aircraft 50 incorporates a heat source 99 and the loop heat pipe 10 for cooling the heat source 99. Examples of the heat source 99 include, but are not limited to: an electronic device including heat-generating parts, such as a control board, an engine control unit (ECU), or a computer; a friction heat-generating mechanical part such as a bearing; a heat-generating element such as a battery; and air inside the cabin.

The evaporator 2 is thermally connected to the heat source 99, and the condenser 3 is located in the cooling chamber 55. In the cooling chamber 55 is disposed a fan 56 for forcing a gas flow to pass the condenser 3. The condenser 3 condenses the working fluid using cold energy from the outside air.

The following describes first to third embodiments of the evaporator 2.

### First Embodiment

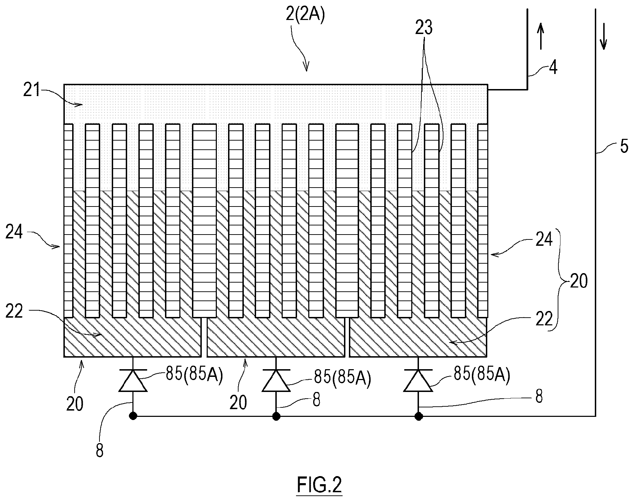

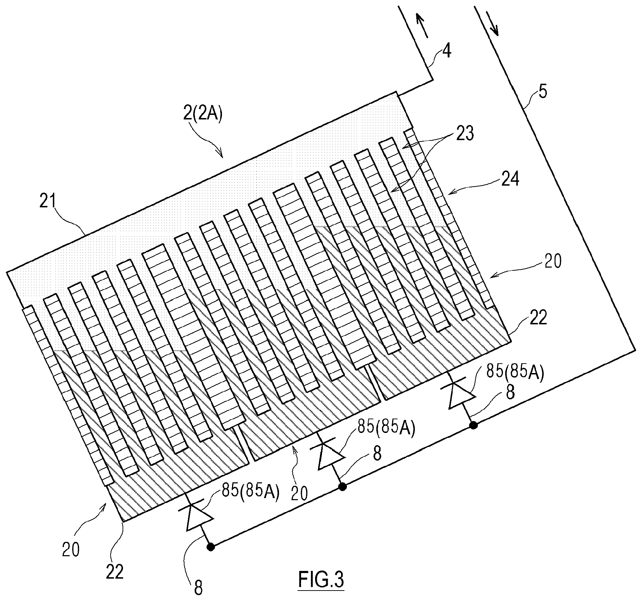

FIG. 2 illustrates the configuration of an evaporator 2A according to the first embodiment, and FIG. 3 is a plan view illustrating the evaporator 2A of FIG. 2 which is in a changed position. The evaporator 2A of FIG. 2 effects heat exchange between a gas-phase heat source fluid such as exhaust gas and a liquid-phase working fluid and thereby changes at least a part of the working fluid from the liquid phase into the gas phase.

The evaporator 2A includes a plurality of heat exchange units 20, a plurality of distribution conduits 8 connected respectively to the heat exchange units 20, and a plurality of valves 85 disposed respectively in the distribution conduits 8. The distribution conduits 8 are connected to one liquid conduit 5.

Each heat exchange unit 20 includes an inlet portion 22 connected to the distribution conduit 8 and a heat exchange portion 24 including at least one heat exchange path 23 extending straight upward from the inlet portion 22. In the first embodiment, the heat exchange portion 24 includes a plurality of heat exchange paths 23, and each heat exchange path 23 is formed by a heat transfer conduit. The working fluid flowing into the heat exchange paths 23 through the inlet portion 22 exchanges heat with the heat source 99 and thus evaporates at least in part during passage through the heat exchange paths 23.

The heat exchange units 20 are arranged in a row in a substantially horizontal direction and located generally at the same level. A "reference position" of the evaporator 2A refers to a position assumed by the evaporator 2A when a transportation machine incorporating the evaporator 2A or a transportation machine incorporating the loop heat pipe 10 including the evaporator 2A is placed on a horizontal surface.

The distribution conduits 8 are connected to the liquid conduit 5. The valves 85 are disposed respectively in the distribution conduits 8. The valves 85 block passage of the working fluid flowing from the heat exchange units 20 toward the distribution conduits 8 at least when the tilt of the heat exchange units 20 is equal to or greater than a predetermined tilt threshold. In the first embodiment, check valves 85A are used as the valves 85. The check valves 85A always permit passage of the liquid-phase working fluid flowing toward the inlet portions 22 and block passage of the liquid-phase working fluid flowing away from the inlet portions 22, regardless of whether the evaporator 2A is tilted.

The upper ends of the heat exchange portions 24 of all the heat exchange units 20 are connected to one outlet portion 21. In the first embodiment, the outlet portion 21 is embodied in the form of a tank extending in the horizontal direction. The outlet portion 21 is connected to the vapor conduit 4. Thus, the flows of the working fluid having passed through the different heat exchange units 20 join at the outlet portion 21, and the resulting flow of the working fluid enters the vapor conduit 4.

As described above, the evaporator 2A according to the first embodiment is incorporated into a transportation machine to change at least a part of a working fluid from a liquid phase into a gas phase by heat absorbed from a heat source 99, and includes: a plurality of heat exchange units 20 that are aligned in a horizontal direction in the transportation machine placed on a horizontal surface and whose positions change together; a plurality of distribution conduits 8 connected respectively to the heat exchange units 20 to supply the working fluid in the liquid phase to the heat exchange units 20; and a plurality of valves 85 disposed respectively in the distribution conduits 8 to block passage of the working fluid flowing from the heat exchange units 20 toward the distribution conduits 8 at least when a tilt of the heat exchange units 20 is equal to or greater than a predetermined threshold. Each heat exchange unit 20 includes an inlet portion 22 connected to the distribution conduit 8 and a heat exchange portion 24. The heat exchange portion 24 includes at least one heat exchange path 23 extending straight upward from the inlet portion 22. The working fluid passing through the heat exchange path 23 exchanges heat with the heat source.

As illustrated in the first embodiment, the valves 85 may be check valves 85A that permit passage of the working fluid flowing from the distribution conduits 8 toward the heat exchange units 20 and that block passage of the working fluid flowing from the heat exchange units 20 toward the distribution conduits 8.

In the evaporator 2A configured as described above, the liquid-phase working fluid entering the distribution conduit 8 from the liquid conduit 5 flows into the inlet portion 22 of the heat exchange unit 20. The liquid-phase working fluid entering the inlet portion 22 is distributed to the heat exchange paths 23 connected to the inlet portion 22. The liquid surface of the working fluid lies between the upper and lower ends of the heat exchange paths 23 due to a head pressure originating from the height difference between the locations of the condenser 3 and evaporator 2. In fact, any distinct liquid surface is not present in a two-phase fluid; however, given that in the working fluid flowing in the heat exchange paths 23, the volume proportion of the gas present in the liquid increases upward, a boundary plane at which the volume percentage of the gas (void percentage) in the gas-liquid two-phase flow is a given value (e.g., 50%) can be assumed as the liquid surface.

In each heat exchange portion 24, heat absorbed from the heat source fluid flowing around the heat exchange portion 24 is released to the working fluid flowing in the heat exchange paths 23. At least a part of the liquid-phase working fluid in the heat exchange paths 23 boils under the action of the heat. The flows of the working fluid changed into the gas phase or the gas-liquid two phase in the heat exchange paths 23 come out of the heat exchange paths 23 and join at the outlet portion 21, and the resulting flow of the working fluid enters the vapor conduit 4.

When the position of the transportation machine incorporating the loop heat pipe 10 including the evaporator 2A changes, the position of the entire loop heat pipe 10 also changes.

FIG. 3 illustrates the evaporator 2A of FIG. 2 which is in a changed position. As shown in FIG. 3, when the evaporator 2A is tilted in the direction in which the heat exchange units 20 are aligned, the liquid-phase working fluid flows in the direction of decreasing potential energy. In this situation, the valves 85 (check valves 85A) block the flows of the working fluid from the heat exchange units 20 toward the distribution conduits 8, thereby preventing the liquid-phase working fluid from flowing out of the heat exchange units 20 into the distribution conduits 8 or flowing out of one heat exchange unit 20 into another heat exchange unit 20 through the distribution conduits 8. Thus, the distribution of the liquid-phase working fluid among the heat exchange paths 23 of the evaporator 2A is less uneven than when the heat exchange units 20 are in communication without intervention of the valves 85 or when all of the heat exchange paths 23 are in communication without intervention of the valves 85 (see FIG. 7). That is, the evaporator 2A of the first embodiment can achieve less uneven distribution of the liquid-phase working fluid among the heat exchange paths 23 in the event of tilting of the evaporator 2A. This can decrease the number of the heat exchange paths 23 in which the liquid-phase working fluid is not present (or the amount of the liquid-phase working fluid is small) in the event of tilting of the evaporator 2A, resulting in effective use of the heat exchange paths 23.

The loop heat pipe 10 according to an exemplary embodiment includes: the above evaporator 2A; a condenser 3 that changes a working fluid from a gas phase into a liquid phase; a vapor conduit 4 connecting an outlet (outlet portion 21) of the evaporator 2A and an inlet of the condenser 3; and a liquid conduit 5 connecting an outlet of the condenser 3 and an inlet (distribution conduit 8) of the evaporator 2A.

As previously stated, the evaporator 2A according to the first embodiment can achieve less uneven distribution of the liquid-phase working fluid among the heat exchange paths 23 in the event of tilting of the evaporator 2A and allow for effective use of the heat exchange paths 23. The loop heat pipe 10 including this evaporator 2A can avoid a decrease in heat transport rate in the event of tilting of the loop heat pipe 10.

### Second Embodiment

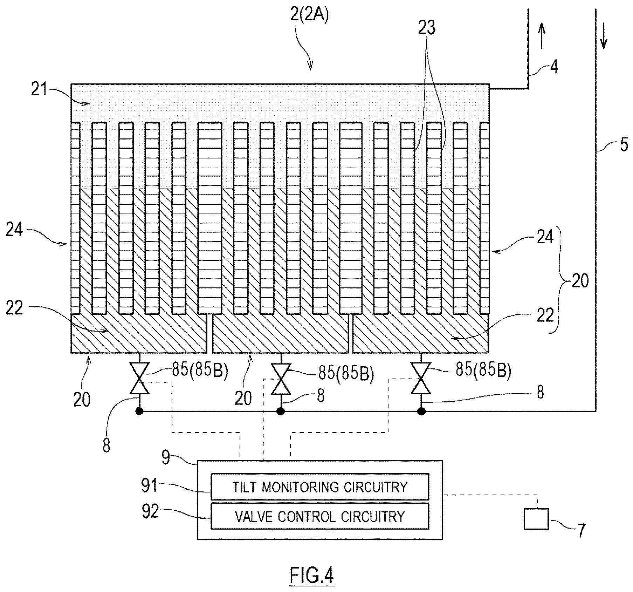

Next, an evaporator 2B according to the second embodiment will be described. FIG. 4 illustrates the configuration of the evaporator according to the second embodiment. For the second embodiment, the elements which are the same as or similar to those of the first embodiment described above are denoted by the same reference signs in the figure and will not be described below.

As shown in FIG. 4, the evaporator 2B according to the second embodiment is characterized by: including control valves 85B controlled by a controller 9 as the valves 85 which are disposed in the distribution conduits 8 in the evaporator 2A according to the first embodiment; and including a tilt sensor 7.

The tilt sensor 7 detects a tilt of the evaporator 2B from the reference position. Since the positions of the heat exchange units 20 of the evaporator 2B change together, a tilt of the evaporator 2B is equivalent to a tilt of the heat exchange units 20. The tilt sensor 7 may be mounted on the evaporator 2B or loop heat pipe 10 itself. Alternatively, the tilt sensor 7 may be mounted on the transportation machine incorporating the evaporator 2B or loop heat pipe 10. Known examples of the tilt sensor 7 include an acceleration sensor and a gyro sensor.

The controller 9 is electrically connected to the tilt sensor 7 by wire or wirelessly, and acquires the values detected by tilt sensor 7. The controller 9 is electrically connected to the control valves 85B by wire or wirelessly and controls the operation of the control valves 85B. The controller 9 includes a tilt monitoring circuitry 91 and a valve control circuitry 92 as functional circuitrys.

The controller 9 is a so-called computer and includes, for example, a processing unit (processor) such as a microcontroller, a CPU, an MPU, a PLC, a DSP, an ASIC, or an FPGA and a storage unit including volatile and non-volatile memories such as a RAM and ROM (neither of these units are shown). The storage unit stores programs to be executed by the processing unit and various kinds of fixed data. In the controller 9, the processing unit retrieves and executes software such as the programs stored in the storage unit, thereby performing procedures for implementing the functional circuitries mentioned above. The controller 9 may consist of a single computer that performs the procedures by centralized control or may be constituted by a plurality of computers cooperative to perform the procedures by distributed control.

The following describes the flow of the control of the control valves 85B by the controller 9. The tilt monitoring circuitry 91 of the controller 9 acquires tilt information from the tilt sensor 7 and determines the tilt of the evaporator 2B from the reference position based on the tilt information. The tilt monitoring circuitry 91 monitors the tilt of the evaporator 2B by comparing the determined tilt to a predetermined tilt threshold.

When the evaporator 2B is in the reference position, the heat exchange paths 23 extend straight in the vertical direction. In the event that the evaporator 2B is tilted from the reference position in the direction in which the heat exchange units 20 are aligned, the liquid-phase working fluid is unevenly distributed among the heat exchange paths 23. If a tilt from the reference position results in a situation where, in at least one of the heat exchange paths 23, the liquid-phase working fluid is not present (or a small amount of the liquid-phase working fluid is present such that blow by of the gas-phase working fluid occurs), such a tilt may be defined as the "tilt threshold". Alternatively, the "tilt threshold" may be a tilt from the reference position that leads to the liquid-phase working fluid being so unevenly distributed among the heat exchange paths 23 as to preclude the evaporator 2B from exhibiting a desired level of heat exchange performance. The tilt threshold is specific to the evaporator 2B and predetermined based on a result of simulation using a model of the evaporator 2B or by experimentation. The tilt threshold is prestored in the controller 9.

When the evaporator 2B is in a steady state, all of the control valves 85B are open. If the determined tilt is greater than the tilt threshold, the tilt monitoring circuitry 91 sends a closing signal to the valve control circuitry 92 and, upon receipt of the closing signal, the valve control circuitry 92 closes the control valves 85B to prohibit the flows of the working fluid. It should be noted that the control valve 85B is kept open for at least one of the heat exchange units 20 of the evaporator 2B to allow the liquid-phase working fluid to move from the liquid conduit 5 to the evaporator 2B. The tilt monitoring circuitry 91 continues monitoring the tilt of the evaporator 2B and, if the determined tilt becomes equal to or smaller than the tilt threshold, sends an opening signal to the valve control circuitry 92. Upon receipt of the opening signal, the valve control circuitry 92 opens the control valves 85B to permit the flows of the working fluid.

As described above, the evaporator 2B according to the second embodiment is incorporated into a transportation machine to change at least a part of a working fluid from a liquid phase into a gas phase by heat absorbed from a heat source 99, and includes: a plurality of heat exchange units 20 that are aligned in a horizontal direction in the transportation machine placed on a horizontal surface and whose positions change together upon tilting of the transportation machine; a plurality of distribution conduits 8 connected respectively to the heat exchange units 20 to supply the working fluid in the liquid phase to the heat exchange units 20; and a plurality of valves 85 disposed respectively in the distribution conduits 8 to block passage of the working fluid flowing from the heat exchange units 20 toward the distribution conduits 8 at least when a tilt of the heat exchange units 20 is equal to or greater than a predetermined threshold. Each heat exchange unit 20 includes an inlet portion 22 connected to the distribution conduit 8 and a heat exchange portion 24. The heat exchange portion 24 includes at least one heat exchange path 23 extending straight upward from the inlet portion 22. The working fluid passing through the heat exchange path 23 exchanges heat with the heat source 99.

In the second embodiment, the valves 85 are control valves 85B, and the evaporator 2B further includes a tilt sensor 7 that detects the tilt of the heat exchange units 20 and a controller 9 that controls operation of the control valves 85 based on the detected tilt. The controller 9 is configured to close the control valves 85B if the detected tilt is greater than the predetermined tilt threshold and open the control valves 85B if the tilt is equal to or smaller than the tilt threshold.

In the evaporator 2B configured as described above and the loop heat pipe 10 incorporating the evaporator 2B, if the tilt of the evaporator 2B is greater than the tilt threshold, the closed control valves 85B block the flows of the working fluid from the heat exchange units 20 toward the distribution conduits 8, thereby preventing the liquid-phase working fluid from flowing out of the heat exchange units 20 into the distribution conduits 8 or flowing out of one heat exchange unit 20 into another heat exchange unit 20 through the distribution conduits 8. As such, in the event of tilting of the evaporator 2B, a decrease in the area of contact between the liquid-phase working fluid and the heat exchange paths 23 (heat transfer conduits) can be avoided to achieve effective use of the heat exchange paths 23.

Additionally, in the second embodiment which employs the control valves 85B as the valves 85, an appropriate value of the tilt threshold can be set depending on factors such as the type of the transportation machine and the environment in which the evaporator 20B is installed.

### Third Embodiment

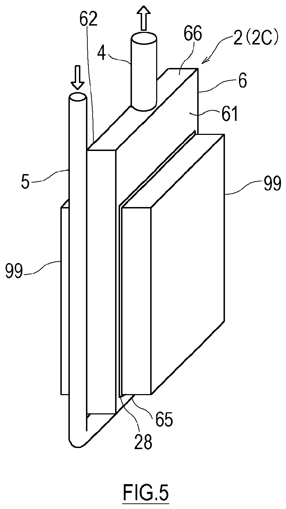

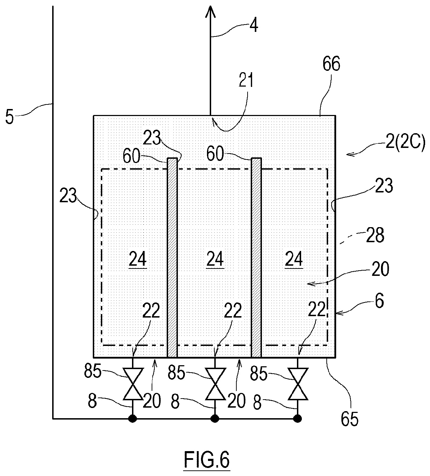

FIG. 5 is a perspective view of a vertically placed evaporator 2C according to the third embodiment, and FIG. 6 illustrates the internal portion of the evaporator 2C of FIG. 5.

For the third embodiment, the elements which are the same as or similar to those of the first embodiment described above are denoted by the same reference signs in the figures and will not be described below.

As shown in FIGS. 5 and 6, the evaporator 2C according to the third embodiment includes: a housing 6 including a front wall 61 and a back wall 62 and formed in the shape of a rectangular parallelepiped in which at least one of the front and back walls 61 and 62 has the largest area; and a heat-absorbing element 28 disposed on at least one of the front and back walls 61 and 62 and thermally connected to a heat source 99.

The housing 6 includes a bottom wall 65 provided with a plurality of inlet portions 22 and a top wall 66 provided with one outlet portion 21. The housing 6 encloses a heat exchange portion 24 including at least one heat exchange path 23 extending straight upward from the inlet portions 22. The inlet portions 22 and the heat exchange portion 24 constitute a heat exchange unit 20. In this example, the housing 6 encloses three heat exchange units 20, and the heat exchange portion 24 of each heat exchange unit 20 includes one heat exchange path 23.

The housing 6 encloses at least one partition wall 60 extending in an upward/downward direction. The bottom of the partition wall 60 is joined to the bottom wall 65 of the housing 6, and the top of the partition wall 60 is spaced apart from the top wall 66. The interior of the housing 6, exclusive of its top region, is divided into a plurality of segments by the partition wall 60, and thus the plurality of heat exchange paths 23 are formed in the housing 6. The heat exchange paths 23 are in communication in that top region of the interior of the housing 6 where the partition wall 60 is not present.

Distribution conduits 8 are connected respectively to the inlet portions 22. Valves 85 are disposed respectively in the distribution conduits 8. The valves 85 block passage of the working fluid flowing from the heat exchange units 20 toward the distribution conduits 8 at least when the tilt of the heat exchange units 20 is equal to or greater than a predetermined tilt threshold. The valves 85 may be the check valves 85A as illustrated in the first embodiment or the control valves 85B as illustrated in the second embodiment.

In the evaporator 2C configured as described above, the liquid-phase working fluid is supplied from the liquid conduit 5 to the inlet portions 22 of the heat exchange units 20 through the distribution conduits 8. The liquid-phase working fluid entering the heat exchange paths 23 through the inlet portions 22 exchanges heat with the heat source 99 and evaporates at least in part while moving upward in the heat exchange paths 23. The top region of the interior of the housing 6 is filled with the gas-phase or gas-liquid two-phase working fluid, and this working fluid flows out of the housing 6 into the vapor conduit 4 through the outlet portion 21.

Also in the case of the evaporator 2C according to the third embodiment, a change in the position of the transportation machine incorporating the loop heat pipe 10 causes a change in the position of the evaporator 2C included in the loop heat pipe 10. In this situation, the valves 85 block the flows of the working fluid from the heat exchange units 20 toward the distribution conduits 8, thereby preventing the liquid-phase working fluid from flowing out of the heat exchange units 20 into the distribution conduits 8 or flowing out of one heat exchange unit 20 into another heat exchange unit 20 through the distribution conduits 8. Thus, the distribution of the liquid-phase working fluid among the heat exchange paths 23 of the evaporator 2C is less uneven than when the heat exchange units 20 are in communication without intervention of the valves 85 or when all of the heat exchange paths 23 are in communication without intervention of the valves 85 (see FIG. 7). That is, the evaporator 2C of the third embodiment can achieve less uneven distribution of the liquid-phase working fluid among the heat exchange paths 23 in the event of tilting of the evaporator 2C. This can decrease the number of the heat exchange paths 23 in which the liquid-phase working fluid is not present (or the amount of the liquid-phase working fluid is small) in the event of tilting of the evaporator 2A, resulting in effective use of the heat exchange paths 23.

Although the foregoing has described preferred embodiments of the present invention, the scope of the present invention embraces modifications made to the details of the portion and/or function of the above embodiments without departing from the concept of the present invention.

For example, the loop heat pipes 10 of the above embodiments are not limited to the thermosyphon type, and may be of the wick type. The loop heat pipe of the wick type uses not only the capillary force acting on the working fluid in the wick but also gravity to return the working fluid from the condenser 3 to the evaporator 2. Thus, the present invention can offer the benefits as described above also when applied to a heat transport system including a loop heat pipe of the wick type.

### Reference Signs List

2, 2A, 2B, 2C: evaporator
3: condenser
4: vapor conduit
5: liquid conduit
7: tilt sensor
8: distribution conduit
9: controller
10: loop heat pipe
20: heat exchange unit
21: outlet portion
22: inlet portion
23: heat exchange path
24: heat exchange portion
6: housing
61: front wall
62: back wall
65: bottom wall
66: top wall
85: valve
85A: check valve
85B: control valve
91: tilt monitoring circuitry
92: valve control circuitry

## Claims

1. An evaporator incorporated into a transportation machine to change at least a part of a working fluid from a liquid phase into a gas phase by heat absorbed from a heat source, comprising:
a plurality of heat exchange units that are aligned in a horizontal direction in the transportation machine placed on a horizontal surface and whose positions change together;
a plurality of distribution conduits connected respectively to the heat exchange units to supply the working fluid in the liquid phase to the heat exchange units; and
a plurality of valves disposed respectively in the distribution conduits to block passage of the working fluid flowing from the heat exchange units toward the distribution conduits at least when a tilt of the heat exchange units is equal to or greater than a predetermined threshold,
each heat exchange unit including:
an inlet portion connected to the distribution conduit; and
a heat exchange portion that includes at least one heat exchange path extending straight upward from the inlet portion and that allows the working fluid passing through the heat exchange path to exchange heat with the heat source.

2. The evaporator according to claim 1, wherein the valves are check valves that permit passage of the working fluid flowing from the distribution conduits toward the heat exchange units and that block passage of the working fluid flowing from the heat exchange units toward the distribution conduits.

3. The evaporator according to claim 1 or 2, wherein
the valves are control valves,
the evaporator further comprises a tilt sensor that detects the tilt of the heat exchange units and a controller that controls operation of the control valves based on the detected tilt, and
the controller is configured to close the control valves if the tilt is greater than the tilt threshold and open the control valves if the tilt is equal to or smaller than the tilt threshold.

4. A loop heat pipe comprising:
the evaporator according to any one of claims 1 to 3;
a condenser that changes the working fluid from the gas phase into the liquid phase:
a vapor conduit connecting an outlet of the evaporator and an inlet of the condenser; and
a liquid conduit connecting an outlet of the condenser and an inlet of the evaporator.
